# EUROPEAN PATENT SPECIFICATION

(11) **EP 0 283 903 B1**
(45) Date of publication and mention of the grant of the patent: **09.06.1993**
(21) Application number: 88104091.9
(22) Date of filing: 15.03.1988
(51) Int. Cl.: C30B 15/12

(54) **Method of manufacturing quartz double crucible and method of manufacturing a silicon monocrystalline rod**
Verfahren zur Herstellung eines Doppeltiegels aus Quarz und Verfahren zur Herstellung eines monokristallinen Siliziumstabes
Procédé pour la fabrication d'un double creuset en quartz et procédé pour la fabrication d'une barre en silicium monocristallin

(30) Priority: 20.03.1987 JP 67128/87
(43) Date of publication of application: 28.09.1988
(73) Proprietor: MITSUBISHI MATERIALS CORPORATION, Chiyoda-ku Tokyo (JP)
(72) Inventor: Kida, Michio, Urawa-shi Saitama-ken (JP); Sahira, Kensho, Yono-shi Saitama-ken (JP)
(74) Representative: Hansen, Bernd, Dr. Dipl.-Chem.

(56) References cited:
- DE-A- 1 194 820
- FR-A- 2 208 849
- GB-A- 816 334
- US-A- 4 352 784

## Description

### BACKGROUND OF THE INVENTION

### Field of the Invention

The present invention relates to a method of manufacturing a quartz double crucible which is utilized for producing silicon crystalline rods.

### Prior Art

Extensively used for manufacturing silicon monocrystal rods is a Czochralski method which comprises the step of pulling a silicon monocrystal rod from a melt in a crucible while continuously adding a silicon material to the melt in order to maintain the quantity of the melt constant.

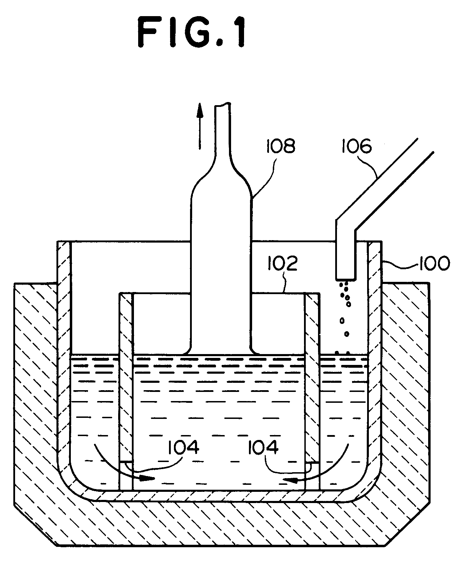

Fig. 1 shows an example of a double crucible utilized in such method which includes an outer crucible 100 and a cylindrical inner crucible member 102 housed within the outer crucible 100 so as to be coaxial therewith. The inner crucible member 102 includes a pair of cut-outs 104 and 104 formed at a lower end thereof, and a pipe 106 for feeding a silicon material is disposed with ifs one end directed toward a space defined between the inner crucible member 102 and the outer crucible 100, whereby the silicon material can be continuously introduced into the space. Thus, by virtue of the provision of the inner crucible member 102, the disturbance produced in the surface of the melt when the silicon material drops into the melt is prevented from being transmitted to a growing portion of a silicon crystalline rod 108, so that the disorder in its crystal structures is positively prevented.

Heretofore, a double crucible as described above has been manufactured by welding the inner crucible member 102 to the outer crucible 100 by hand by using an oxyhydrogen flame burner or the like. However, much time and labor have been required in the welding work, and therefore the manufacturing cost has been increased unduly. Particularly, the problem of the increased cost has become more serious with the recent tendency that the diameter of the crucible is getting greater.

### SUMMARY OF THE INVENTION

It is therefore an object of the present invention to provide a method by which a quartz double crucible can be easily manufactured at a substantially reduced cost.

Another object of the present invention is to provide a method of producing a silicon crystalline rod which can be conducted in succession while leaving the double crucible manufactured by the above method as it is.

According to a first aspect of the present invention, there is provided a method of manufacturing a quartz double crucible according to claim 1.

According to a second aspect of the present invention, there is provided a method of manufacturing a silicon monocrystalline rod according to claim 5.

### BRIEF DESCRIPTION OF THE DRAWINGS

Fig. 1 is a schematic cross-sectional view showing a conventional double crucible used in the manufacture of silicon crystalline rods; and
Figs. 2 and 3 are schematic cross-sectional views showing a method of manufacturing a double crucible according to the present invention.

### DESCRIPTION OF PREFERRED EMBODIMENTS OF THE INVENTION

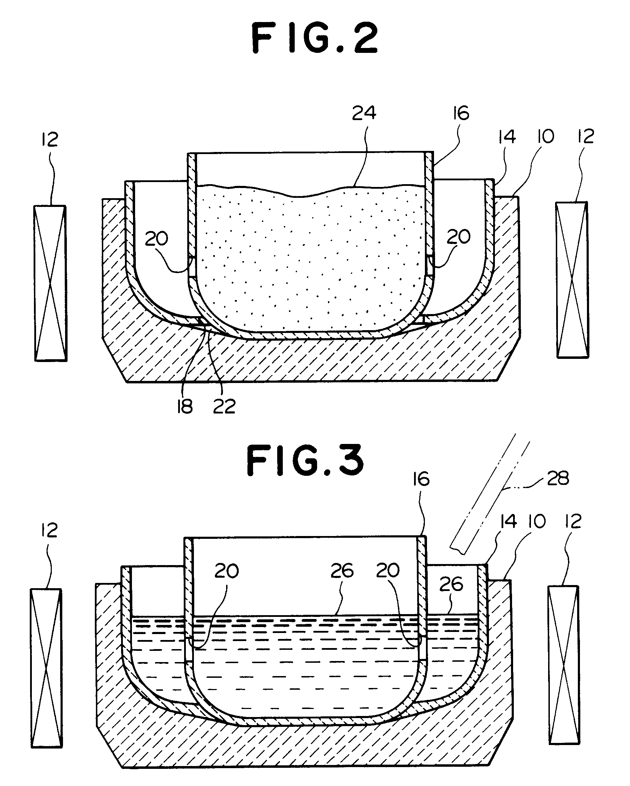

Referring to Figs. 2 and 3, there is illustrated an apparatus for pulling silicon monocrystal rods from a melt. The apparatus comprises a susceptor or vessel 10 of graphite housed in a furnace (not shown) and heating means 12 such as a resistance heater disposed so as to surround the susceptor 10. A double crucible of quartz, which is to be manufactured according to the present invention, is to be accommodated in and supported by the susceptor 10, and comprises a bottom and outer and inner cylindrical peripheral walls extending from the bottom, the inner peripheral wall having a pair of diametrically opposed apertures formed therethrough.

For manufacturing the above-mentioned double crucible in accordance with the method of claim 1, a larger-diameter crucible 14 or an outer crucible member and a smaller-diameter crucible 16 or an inner crucible member are first prepared. Thereafter, a circular opening 18 with a diameter slightly smaller than the outer diameter of the smaller-diameter crucible 16 is formed in the bottom of the larger-diameter crucible 14 at its central portion, and a pair of diametrically opposed apertures 20 are formed through the peripheral wall of the smaller-diameter crucible 16, each aperture 20 being disposed at a portion lower than the vertically central portion of the peripheral wall. Subsequently, the bottom of the smaller-diameter crucible 16 is fitted into the opening 18 of the larger-diameter crucible 14, and both the crucibles 14 and 16 are placed in and supported by the susceptor 10 in such a manner that a slight gap is formed between the periphery of the opening 18 and the outer periphery of the smaller-diameter crucible 16.

As seen from Fig. 2, the susceptor 10 is formed such that its inner surface can be held in contact with almost the entire outer surfaces of the bottom of the smaller-diameter crucible 16 and the larger-diameter crucible 14 except those portions of the crucibles to be joined together. In other words, an annular gap 22 of a small volume is formed between the inner surface of the susceptor 10 and those portions of the crucibles to be joined together.

Subsequently, the smaller-diameter crucible 16 is filled with a silicon material 24 in the form of lumps which preferably have sizes greater than the diameter of the apertures 20, and the crucibles 14 and 16 are heated by the resistance heater 12 to a temperature of about 1350°C to about 1650°C. As a result, that portion of the smaller-diameter crucible disposed above the gap 22 gets soft and is deformed downwardly thanks to its own weight and the weight of the melt, so that the gap 22 is plugged up. Thus, the adjacent portions of the crucibles adhere to each other, and a double quartz crucible is manufactured.

In the foregoing, the silicon material 24 contained in the smaller-diameter crucible 16 becomes molten when heated, and ultimately some flows through the apertures 20 into the larger-diameter crucible 14, as at 26. However, before the silicon melt begins to flow into the larger-diameter crucible 14, the manufacture of the double crucible is completed. Further, in order that the gap 22 is plugged up with the quartz material of the smaller-diameter crucible 16, the gas contained in the gap 22 has to be released therefrom. For effecting such releasing, a vent may be mounted on the susceptor 10. However, inasmuch as the susceptor 10 is conventionally comprised of several parts joined together, the gas can be usually released through a slit or gap between the parts. In addition, the gas may pass between the susceptor 10 and the larger-diameter crucible 14 since the the contact surfaces thereof have some roughness.

Further, the volume and shape of the annular gap 22 formed between the susceptor 10 and the crucibles 14 and 16 should be determined in such a manner that when softened by heating, the smaller-diameter crucible is deformed to plug up the gap 22 entirely, thereby permitting all the outer surface of the double crucible thus formed to be brought into contact with the inner surface of the susceptor 10.

Further, the temperature to which the crucibles 14 and 16 are heated may be varied, but should be within the above range. If the temperature is below 1350°C, then the crucibles 14 and 16 cannot get softened to a sufficient degree, and therefore cannot be joined successfully. On the other hand, if the temperature exceeds 1650°C, the crucibles are subjected to an excessive softening, resulting in an adversely deformed double crucible.

A quartz double crucible is thus manufactured, but in the present invention, silicon monocrystal rods can be manufactured in succession while leaving the double crucible thus manufactured as it is. Specifically, as is the case with a conventional process, a seed crystal is immersed in the melt contained in the smaller-diameter crucible 16, i.e., in an inner crucible member of the double crucible. Thereafter, the seed crystal is pulled by a usual pulling means from the melt 26 while silicon material in the form of granules are supplied through a feed pipe 28 into a space between the peripheral walls of the crucibles 14 and 16, i.e., in an outer crucible member, and thus a silicon monocrystal rod is produced.

The present invention will now be described in more detail by way of the following example.

### Example

There were prepared two conventional quartz crucibles 14 and 16 of 0,3 and 0,25 m (12 an 10 inches) in diameter, respectively, and then a circular opening 18 and apertures 20 as described above were formed in the crucible 14. Thereafter, the crucibles 14 and 16 were received in the susceptor 10 in such a manner as to define an annular gap 22 therebetween, and the crucible 16 was filled with 12 Kg of lump silicon material. Subsequently, the air in the furnace was replaced by argon gas, and an electric power was applied to the resistance heater 12 and the susceptor 10 was heated to about 1600°C. As a result, the silicon material contained in the crucible 16 became molten and some flowed from the crucible 16 through the apertures 20 into the crucible 14. Before the molten silicon material began to flow into the crucible 14, that portion of the crucible 16 disposed above the gap 22 was deformed so as to plug up the gap 22 and adhered to the crucible 14, and those portions of the crucibles joined together were held into contact with the inner surface of the susceptor 10. Thus, the melt 26 flowing through the apertures 22 into the crucible 14 was successfully held in the crucible 14 without any leakage.

Further, a usual pulling method was conducted in success ion while leaving the double crucible thus manufactured as it was, and a monocrystal rod of 0,10 m (4 inches) in diameter having no defects in its crystal structure was easily produced.

As described above, the method in accordance with the present invention comprises only the steps of receiving the appropriate outer and inner crucible members in the susceptor and heating them to an appropriate temperature. Accordingly, a conventional apparatus for pulling crystalline rods can be utilized for manufacturing the double crucible. Besides, although in the prior art method, the welding of the inner crucible member to the outer crucible requires much time and labor, such welding work is not required at all in the method of the present invention. In addition, inasmuch as quartz crucibles of the type hitherto used can be utilized as the outer and inner crucible members, it is not necessary to prepare any crucible blanks of an intricate shape. Therefore, the productivity of double crucibles can be highly enhanced, and its manufacturing cost can be reduced substantially.

Further, as described above, the joining of the outer and inner crucible members can be conducted effectively and completely by filling the inner crucible member with silicon material prior to the heating step. What is more, the manufacture of the crystalline rods can be commenced while leaving the double crucible manufactured as it is.

While the method according to the present invention has been specifically shown and described herein, many modifications and variations are possible in the light of the above teachings. For example, silicon material need not necessarily be supplied into the inner crucible member prior to the heating step. Further, although in the above embodiment, the bottom of the inner crucible member cooperates with the bottom of the outer crucible member to define the bottom of the double crucible, a cylindrical inner crucible having no bottom may be utilized in combination with an outer crucible member having no opening formed in its bottom, as is the case with the double crucible as shown in Fig. 1. In addition, the crucible members may be disposed in the susceptor in such a manner that the inner periphery of the opening of the outer crucible member is held in contact with the inner crucible member.

## Claims

1. A method of manufacturing a quartz double crucible having a bottom and outer and inner peripheral walls each extending from said bottom, said inner peripheral wall having at least one aperture (20) formed therethrough, comprising the steps of:
(a) preparing outer and inner crucible members (14, 16) each made of quartz, said outer and inner crucible members (14, 16) being such that when said inner crucible member (16) is received in said outer crucible member (14), said outer and inner crucible members define said outer and inner peripheral walls, respectively, while at least one of said outer and inner crucible members defines said bottom;
(b) receiving said inner crucible member (16) in said outer crucible member (14) and placing said inner and outer crucible members in a susceptor (10); and
(c) joining said outer and inner crucible members together, **characterized** in that
said susceptor (10) is a graphite susceptor provided in a crystal pulling apparatus, and that said joining step (c) includes heating said outer and inner crucible members (14, 16) to a temperature of about 1350°C to about 1650°C by means of a heater (12) provided in said crystal pulling apparatus.

2. A method according to claim 1, wherein said inner crucible member (16) is provided with a bottom while said outer crucible member (14) is provided with a bottom having an opening (18) formed therethrough and disposed centrally thereof, whereby the bottom of the inner crucible member (16) cooperates with the bottom of the outer crucible member (14) to define the bottom of the double crucible, and wherein in said receiving step (b) said inner and outer crucible members (14, 16) are placed in said susceptor (10) in such a manner that a gap (22) is defined between said susceptor (10) and those portions of said crucible members disposed adjacent to each other.

3. A method according to claim 1, wherein said inner crucible member (16) is of a tubular shape while said outer crucible member (14) is provided with a bottom which defines the bottom of the double crucible.

4. A method according to claim 2, further comprising the step of charging said inner crucible member (16) with a silicon material (24) prior to said joining step (c).

5. A method of manufacturing a silicon monocrystalline rod by using a quartz double crucible having a bottom and outer and inner peripheral walls each extending from said bottom, said inner peripheral wall having at least one aperture (20) formed therethrough, comprising the steps of:
(a) providing a susceptor (10) made of graphite, outer and inner crucible members (14, 16) each made of quartz, said outer and inner crucible member being such that when said inner crucible member is received in said outer crucible member, said outer and inner crucible members define said outer and inner peripheral walls, respectively, while at least one of said outer and inner crucible members defines said bottom;
(b) receiving said inner crucible member in said outer crucible member and placing said inner and outer crucible members (14, 16) in said susceptor (10);
(c) subsequently charging said inner crucible member with a silicon material (24);
(d) subsequently heating said outer and inner crucible members to a temperature of about 1350°C to about 1650°C, to thereby cause said outer and inner crucible members to be joined together to produce the double crucible and to cause the silicon material (24) in said inner crucible member (16) to melt;
(e) subsequently immersing a seed crystal in the silicon material melt; and
(f) subsequently pulling out said seed crystal from the melt in such a manner that a single-crystalline rod is grown while supplying a silicon material into a space between the peripheral walls of said double crucible.

## Patentansprüche

1. Ein Verfahren zur Herstellung eines Quarz-Doppelschmelztiegels mit einem Boden und jeweils einer von dem besagten Boden ausgehenden äußeren und inneren Umfangswand, wobei die besagte innere Umfangswand mindestens eine durch sie hindurch gebildete Öffnung (20) aufweist, umfassend die Schritte:
(a) Vorbereiten eines jeweils aus Quarz hergestellten äußeren und inneren Schmelztiegelbauteils (14, 16), wobei das besagte äußere und innere Schmelztiegelbauteil derart sind, daß beim Aufnehmen des besagten inneren Schmelztiegelbauteils (16) in dem besagten äußeren Schmelztiegelbauteil (14) das besagte äußere bzw. innere Schmelztiegelbauteil die besagte äußere bzw. innere Umfangswand bilden, während mindestens eines der besagten äußeren und inneren Schmelztiegelbauteile den besagten Boden bildet;
(b) Aufnehmen des besagten inneren Schmelztiegelbauteils (16) in dem besagten äußeren Schmelztiegelbauteil (14) und Anbringen der besagten äußeren und inneren Schmelztiegelbauteile in einer Aufnahme (10); und
(c) Verbinden des besagten äußeren und inneren Schmelztiegelbauteils, dadurch gekennzeichnet, daß
die besagte Aufnahme (10) eine in einer Kristallzieh-Vorrichtung vorgesehene Graphitaufnahme ist, und daß der besagte Verbindeschritt (c) Erhitzen der besagten äußeren und inneren Schmelztiegelbauteile (14, 16) auf eine Temperatur von etwa 1350°C bis etwa 1650°C mittels einer in der besagten Kristallzieh-Vorrichtung vorgesehenen Heizung (12) einschließt.

2. Ein Verfahren nach Anspruch 1, dadurch gekennzeichnet, daß das besagte innere Schmelztiegelbauteil (16) mit einem Boden versehen ist, während das besagte äußere Schmelztiegelbauteil (14) mit einem Boden versehen ist, der eine durch ihn hindurch gebildete und in seiner Mitte angeordnete Öffnung (18) besitzt, wodurch der Boden des inneren Schmelztiegelbauteils (16) zusammen mit dem Boden des äußeren Schmelztiegelbauteils (14) dazu beiträgt, den Boden des Doppelschmelztiegels zu bilden, und daß bei dem besagten Aufnahmeschritt (b) das besagte äußere und innere Schmelztiegelbauteil (14, 16) in einer derartigen Weise in der besagten Aufnahme (10) angebracht werden, daß ein Spalt (22) zwischen der besagten Aufnahme (10) und den aneinander angrenzenden Teilen der besagten Schmelztiegelbauteile gebildet wird.

3. Ein Verfahren nach Anspruch 1, dadurch gekennzeichnet, daß das besagte innere Schmelztiegelbauteil (16) von rohrförmiger Gestalt ist, während das besagte äußere Schmelztiegelbauteil (14) mit einem Boden versehen ist, der den Boden des Doppelschmelztiegels bildet.

4. Ein Verfahren nach Anspruch 2, dadurch gekennzeichnet, daß es weiter den Schritt Beschicken des inneren Schmelztiegelbauteils (16) mit einem Siliziummaterial (24) vor dem besagten Verbindeschritt (c) umfaßt.

5. Ein Verfahren zur Herstellung einer Siliziumeinkristallstange unter Verwendung eines Quarz-Doppelschmelztiegels mit einem Boden und einer jeweils von dem besagten Boden ausgehenden äußeren und inneren Umfangswand, wobei die besagte innere Umfangswand mindestens eine durch sie hindurch gebildete Öffnung (20) besitzt, umfassend die Schritte:
(a) Bereitstellen einer aus Graphit hergestellten Aufnahme (10), einem jeweils aus Quarz hergestellten äußeren und inneren Schmelztiegelbauteil (14, 16), wobei das besagte äußere und innere Schmelztiegelbauteil derart sind, daß beim Aufnehmen des besagten inneren Schmelztiegelbauteils in dem besagten äußeren Schmelztiegelbauteil das besagte äußere bzw. innere Schmelztiegelbauteil die besagte äußere bzw. innere Umfangswand bilden, während mindestens eines der besagten äußeren und inneren Schmelztiegelbauteile den besagten Boden bildet;
(b) Aufnehmen des besagten inneren Schmelztiegelbauteils in dem besagten äußeren Schmelztiegelbauteil und Anbringen der besagten äußeren und inneren Schmelztiegelbauteile (14, 16) in der besagten Aufnahme (10);
(c) nachfolgend Beschicken des besagten inneren Schmelztiegelbauteils mit einem Siliziummaterial (24);
(d) nachfolgend Erhitzen des besagten äußeren und inneren Schmelztiegelbauteils auf eine Temperatur von etwa 1350°C bis etwa 1650°C, um dadurch zu bewirken, daß sich das äußere und innere Schmelztiegelbauteil miteinander verbinden und den Doppelschmelztiegel bilden, und um zu bewirken, daß das Siliziummaterial (24) in dem besagten inneren Schmelztiegelbauteil (16) schmilzt;
(e) nachfolgend Eintauchen eines Impfkristalls in die Siliziummaterialschmelze; und
(f) nachfolgend Herausziehen des besagten Impfkristalls aus der Schmelze in einer solchen Weise, daß eine Einkristallstange gezüchtet wird, während ein Siliziummaterial in einen Raum zwischen den Umfangswänden des besagten Doppelschmelztiegels zugeführt wird.

## Revendications

1. Procédé de fabrication d'un creuset double en quartz ayant un fond et des parois périphériques interne et externe s'étendant chacune depuis ledit fond, ladite paroi périphérique interne comportant au moins une ouverture (20) qui la traverse, procédé comportant les étapes suivantes:
(a) préparation des éléments formant creuset externe et interne (14, 16), chacun fait de quartz, lesdits éléments formant creuset externe et interne (14, 16) étant tels que, quand ledit élément (16) formant creuset interne est logé dans ledit élément (14) formant creuset externe, lesdits éléments formant creuset externe et interne définissent respectivement lesdites parois périphériques externe et interne, alors que au moins l'un desdits éléments formant creuset externe et interne définit ledit fond ;
(b) installation dudit élément formant creuset interne (16) dans ledit élément formant creuset externe (14) et installation desdits éléments formant creuset interne et externe dans un récipient (10) ; et
(c) liaison desdits éléments formant creuset interne et externe l'un à l'autre,
caractérisé en ce que ledit récipient (10) est un récipient en graphite placé dans un appareil de traction de cristal, et en ce que ladite étape de liaison (c) comporte le chauffage desdits éléments (14, 16) formant creuset externe et interne à une température comprise entre 1350°C et 1650°C environ, au moyen d'un élément chauffant (12) placé dans ledit appareil de traction du cristal.

2. Procédé selon la revendication 1, dans lequel ledit élément formant creuset interne (16) est pourvu d'un fond, alors que ledit élément formant creuset externe (14) est pourvu d'un fond comportant une ouverture (18) qui le traverse et est placée en son centre, grâce à quoi le fond de l'élément formant creuset interne (16) coopère avec le fond de l'élément formant creuset externe (14) pour définir le fond du creuset double, et dans lequel dans l'étape d'installation (b), lesdits éléments formant creuset interne et externe (14, 16) sont placés dans ledit récipient (10) de telle façon qu'un espace (22) soit délimité entre ledit récipient (10) et ces parties desdits éléments formant creuset placées adjacentes l'une à l'autre.

3. Procédé selon la revendication 1, dans lequel ledit élément formant creuset interne (16) a une forme tubulaire alors que ledit élément formant creuset externe (14) est pourvu d'un fond qui définit le fond du creuset double.

4. Procédé selon la revendication 2, comportant en outre l'étape de chargement dudit élément formant creuset interne (16) par du silicium (24) avant ladite étape de liaison (c).

5. Procédé de fabrication d'une barre de silicium monocristallin utilisant un creuset double en quartz qui comporte un fond et des parois périphériques interne et externe s'étendant chacune depuis ledit fond, ladite paroi périphérique interne comportant au moins une ouverture (20) qui la traverse, procédé qui comporte les étapes suivantes:
(a) préparation d'un récipient (10) en graphite, d'éléments formant creuset externe et interne (14, 16), tout deux en quarts, lesdits éléments formant creuset externe et interne étant tels que, quand ledit élément formant creuset interne est logé dans ledit élément formant creuset externe, lesdits éléments formant creuset externe et interne définissent respectivement lesdites parois périphériques externe et interne, alors que au moins l'un desdits éléments formant creuset interne et externe définit ledit fond ;
(b) installation dudit élément formant creuset interne dans ledit élément formant creuset externe et installation desdits éléments (14, 16) formant creuset interne et externe dans ledit récipient (10) ;
(c) remplissage ultérieur en silicium (24) dudit élément formant creuset interne ;
(d) chauffage ultérieur desdits éléments formant creuset interne et externe à une température comprise entre 1350°C et 1650°C environ, pour ainsi amener lesdits éléments formant creuset interne et externe à être liés l'un à l'autre afin de produire le creuset double et pour amener le silicium (24) dans ledit élément formant creuset interne (16) à fondre ;
(e) immersion d'un germe de cristal dans le silicium fondu ; et
(f) traction dudit germe de cristal depuis le liquide de telle façon que l'on fasse croître une barre monocristalline tout en envoyant du silicium dans un espace compris entre les parois périphériques dudit creuset double.
